# EUROPEAN PATENT APPLICATION

(11) **EP 0 844 706 A2**
(43) Date of publication of application: **27.05.1998**
(21) Application number: 97119091.3
(22) Date of filing: 31.10.1997
(51) Int. Cl.: H01S 3/06, H01S 3/0941, H01S 3/25

(54) **Optical amplifier and laser light generating apparatus**

(30) Priority: 21.11.1996 JP 310508/96
(71) Applicant: Kokusai Denshin Denwa Kabushiki Kaisha, Tokyo 163-03 (JP)
(72) Inventor: Edagawa, Noboru, c/o Kokusai Denshin Denwa K.K., Shinjuku-ku, Tokyo (JP); Akiba, Shigeyuki, c/o Kokusai Denshin Denwa K.K., Shinjuku-ku, Tokyo (JP)
(74) Representative: Schaumburg, Thoenes & Thurn

(57) **Abstract**

In order to prevent two pumping lasers (54,56) from overlapping in oscillation wavelength due to injection locking by return light in a apparatus using double pumping lasers, the apparatus is configured to enter optical outputs from the pumping lasers into a fiber grating (60) using a PANDA fiber through a half mirror and to reflect them back to the pumping lasers. The fiber grating has two main axes whose reflective wavelengths λ1, λ2 are different only by approximately 0.4 nm, and locks the laser oscillation wavelength of one of the pumping lasers to the wavelength λ1 and the laser oscillation wavelength of the other pumping laser to the wavelength λ2. Light passing through the fiber grating is entered into erbium-doped optical fibers (48U,48D) through a 3 dB coupler and WDM couplers (50U,50D) to excite the erbium-doped optical fibers.

## Description

### FIELD OF THE INVENTION

This invention relates to an optical amplifier and a laser light generating apparatus, and more particularly, to an optical amplifier for use in an optical repeater of an optical fiber transmission system and a laser light generating apparatus suitable as a pumping light source of the optical amplifier.

### BACKGROUND OF THE INVENTION

An optical amplifier used in an optical repeater of an optical fiber transmission system is configured to enter an optical signal into an optically amplifying fiber doped with a rare earth (typically, erbium) and to introduce pumping light (typically, laser light in the band of 1,480 nm) through a WDM coupler. The optically amplifying fiber amplifies the received optical signal, and its output light is delivered to a transmission optical fiber through an optical isolator.

Submarine optical cable systems basically comprise a pair of up and down optical fiber lines, and each repeater is equipped with an up-line optical amplifier and a down-line optical amplifier. When two optically amplifying fibers are pumped by multiplexing and dividing light from two pumping lasers rather than independently pumped by two pumping lasers, systems are more resistant because, even upon a trouble in one of pumping lasers, the other pumping laser serves to maintain up-line and down-line optical amplifiers operative.

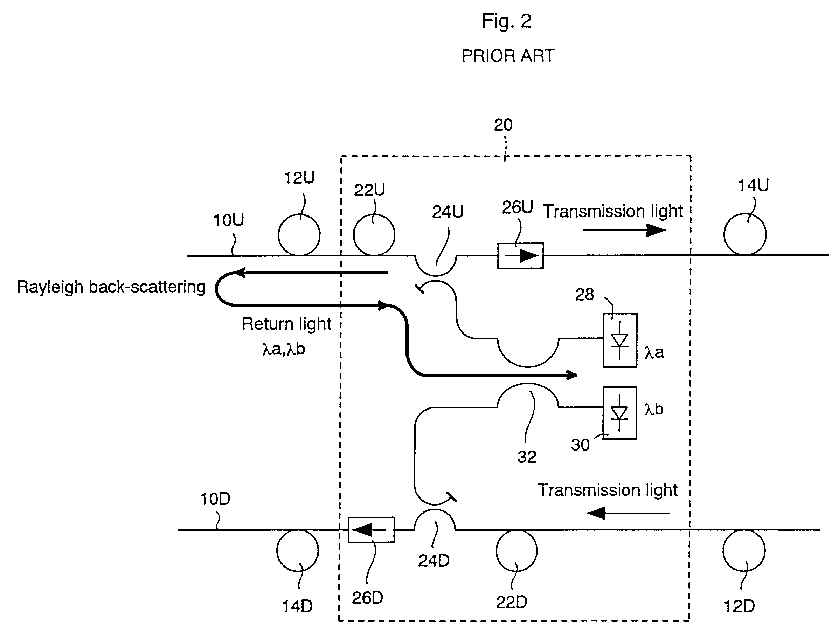

Fig. 2 is a schematic block diagram showing a general construction of a conventional system of this type. Light from a transmission optical fiber 12U in an up-flow optical line 10U enters into an optically amplifying repeater 20 and, after being amplified there, enters into a next transmission optical fiber 14U in the up-flow optical line 10U. Light from a transmission optical fiber 12D in the down-flow optical line 10D enters into the optically amplifying repeater 20 and, after being amplified there, enters into a next transmission optical fiber 14D in the down-flow optical line 10D.

In the optically amplifying repeater 20, light from the transmission optical fiber 12U and light from the transmission optical fiber 12D enter into the transmission optical fibers 14U and 14D through erbium-doped optical fiber 22U and 22D, wavelength-division multiplexing (WDM) couplers 24U, 24D and optical isolators 26U, 26D, respectively.

Pumping lasers 28 and 30 are operative for multi-mode laser oscillation in the band of 1,480 nm, and their oscillation wavelengths λa and λb, individually, are slightly different and not correlated. Outputs from pumping lasers 28, 30 undergo multiplexing/dividing processing in a 3 dB coupler 32. The 3 dB coupler 32 may be an optical fiber coupler, for example. One of optical outputs from the 3 dB coupler 32 is entered into the WDM coupler 24U, and coupled to the optical line connecting the erbium-doped optical fiber 22U to pump it. The other output light from the 3 dB coupler 32 is entered into the WDM coupler 24D, and coupled to the optical line connecting the erbium-doped optical fiber 22D to pump it. Inside the erbium-doped optical fibers 22U and 22D, pumping light travels in the opposite direction from the signal light.

Each of the WDM couplers 24U and 24D is non-reflectively terminated at one end to prevent reflection of part of the pumping light supplied from the 3 dB coupler 32 but not coupled to the erbium-doped optical fibers 22U and 22D.

In the double construction using the 3 dB coupler 32, even when any damage occurs in one of the pumping lasers, e.g. laser 28, both erbium-doped optical fibers 22U and 22D can be pumped by output light from the other laser 30, and the reliability of the system can be increased. Therefore, it is sufficient to use the 3 dB coupler 32, and the system is economical.

However, in the redundant construction shown in Fig. 2, residual pumping light, which the erbium-doped optical fibers 22U and 22D failed to absorb, enters into the transmission optical fibers 12U and 12D, returns to the erbium-doped optical fibers 22U and 22D due to Rayleigh back-scattering while traveling through the transmission optical fibers 12U and 12D, and travels through the erbium-doped optical fibers 22U and 22D in the same direction as the signal light. In most cases, optical power traveling back due to Rayleigh back-scattering is as weak as approximately 30 dB less than the incident power. However, when the line width for the incident light is sufficiently thin, it may increase by stimulated Brillouin scattering. Pumping light traveling through the erbium-doped optical fibers 22U and 22D in the same direction as the signal light is coupled to the 3 dB couplers 32 by the WDM couplers 24U and 24D, and enters into the pumping lasers 28 and 30. Return light entering into the pumping lasers 28 and 30 includes both wavelengths λa and λb.

When return light caused by Rayleigh back-scattering enters into the pumping lasers 28 and 30, it causes an mutual interference and injection-locking of oscillation wavelengths between two pumping lasers 28 and 30. As a result, oscillation wavelengths λa and λb of these pumping lasers 28 and 30 may occasionally coincide and be locked in phase. Once the pumping lasers 28 and 30 coincide in oscillation wavelength and lock in phase, the 3 dB coupler 32 functions also as an interferometer, and the dividing rate of the 3 dB coupler 32 sensitively varies in response to the interference condition determined by the phase relationship between these two pumping lights. Such an interfering phenomenon is unstable with time, and causes fluctuation in pumping light power supplied to the erbium-doped optical fibers 22U and 22D and unstable behaviors of the repeater 20.

A simple approach to avoid it is to provide optical isolators at output stages of the pumping lasers 28 and 30 for preventing entrance of return light. However, since the insertion loss of optical isolators is large, this approach must increase output powers of the pumping lasers 28 and 30 so much, and hence shortens the life of the pumping lasers 28 and 30. Especially for laser diodes in the band of 980 nm remarked as low-noise pumping light, it is considered that the life of a laser diode is shortened inverse-proportionally to the quadruple self-multiplication of its output power, and an optical isolator with a large insertion loss cannot be used.

### SUMMARY OF THE INVENTION

It is therefore an object of the invention to provide an optical amplifier overcoming the above-mentioned problems and preventing influences of return light to oscillation wavelengths of pumping lasers, and a laser light generating apparatus suitable for use as a pumping light source.

According to the invention, oscillation wavelengths of a plurality of pumping lasers for generating pumping light are locked at predetermined values slightly different from each other by wavelength locking means. Thus, respective oscillation wavelengths are stably controlled against return light, if any, and it is prevented that oscillation wavelengths of a plurality of pumping lasers coincide undesirably. That is, no particular means for removing return light is required. As a result, the invention can fully remove the problems involved in the conventional devices, namely, fluctuation in intensity of pumping light, fluctuation in amplification characteristics thereby.

The wavelength locking means preferably includes multiplexing means for multiplexing optical outputs from a plurality of pumping lasers in different directions of polarization, and reflecting means for reflecting at least a part of output light from the multiplexing means in slightly different reflective wavelengths in response to the directions of polarization. In this manner, oscillation wavelengths of a plurality of pumping lasers can be controlled stably with a very small difference therebetween.

By using as the reflecting means a diffraction grating element made of a birefringent optical material, such as fiber grating using a polarization-preserving fiber, a wavelength difference as small as 0.4 nm can be realized. The latter makes it possible to arrange a construction suitable for optical fiber transmission.

The multiplexing means may be transmitting/reflecting means with a polarization selective property for passing light in one of two crossing directions of polarization at right angles and for reflecting light in the other direction of polarization. Thus, a construction suitable for use of two pumping lasers is obtained.

Providing pumping light transmission means for supplying light through the reflecting means to each of one or more optically amplifying mediums, pumping light can be supplied to one or more optically amplifying mediums. The optically amplifying medium may be an optical fiber doped with a rare earth, represented by erbium-doped optical fiber.

The invention is also applicable to a laser light generating apparatus for generating laser light stable in wavelength and including a plurality of slightly different wavelengths.

### BRIEF DESCRIPTION OF THE DRAWINGS

Fig. 1 is a schematic block diagram showing a general construction of a system emoodying the invention; and
Fig. 2 is a schematic block diagram showing a general construction of a conventional system.

### DESCRIPTION OF THE PREFERRED EMBODIMENT

Embodiments of the invention are explained below in detail with reference to the drawing.

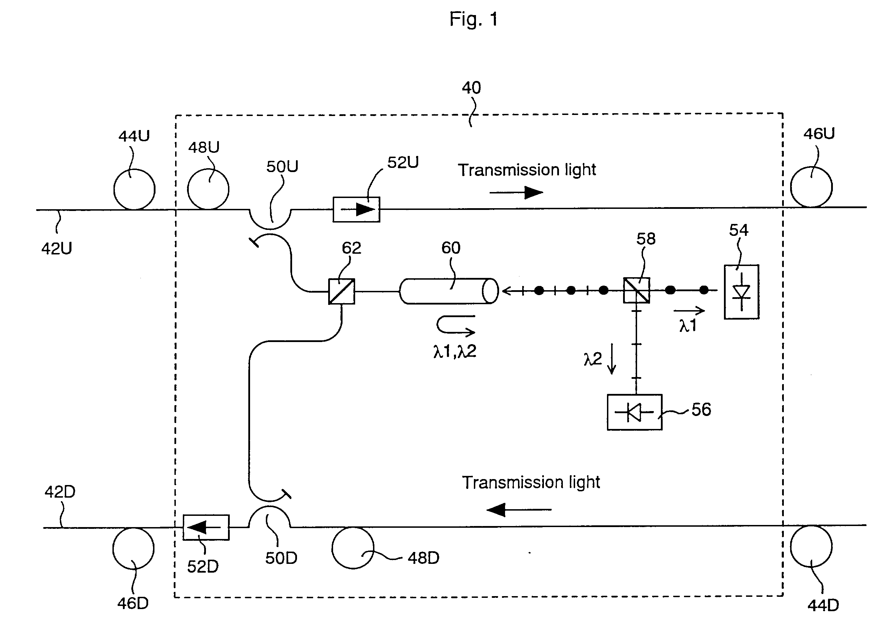

Fig. 1 is a block diagram schematically showing an embodiment of the invention. Reference numeral 40 denotes an optical amplifier embodying the invention, which is connected between transmission optical fibers 44U and 46U in an up-flow optical line 42U and between transmission optical fibers 44D and 46D in a down-flow optical line 42D. Light propagating through the up-flow optical line 42U and down-flow optical line 42D is in the band of 1,550 nm in case of long-distance transmission.

In the optical amplifier 40, output light from the transmission optical fiber 44U in the up-flow optical line 42U enters into the transmission optical fiber 46U via an erbium-doped optical fiber 48U, wavelength-division multiplexing (WDM) coupler 50U and optical isolator 52U. On the other hand output light from the transmission optical fiber 44D in the down-flow optical line 42D enters into the transmission optical fiber 46D via an erbium-doped optical fiber 48D, wavelength-division multiplexing coupler 50D and optical isolator 52D. Optical isolators 52U and 52D are oriented to remove reflected light from the transmission optical fibers 46U and 46D located downstream of them.

Wavelength-division multiplexing (WDM) couplers 50U and 50D cross-connect pumping light to the erbium-doped optical fibers 48U and 48D in a direction opposite from the propagating direction of signal light to be amplified. Through-output port for the pumping light are terminated non-reflective.

Numerals 54 and 56 denote pumping laser diodes (hereinafter called pumping lasers) which are designed and driven to laser-oscillate in wavelengths near λ1 and λ2 slightly different from each other, and are located so that directions of polarization of their optical outputs cross at right angles. The pumping lasers 54 and 56 may comprise pumping laser modules alone. Alternatively, polarization-preserving single-mode fibers ( for example, PANDA fibers) may be connected to outputs of such pumping laser modules to establish the above-mentioned relation of polarization. Regarding the wavelengths λ1 and λ2, the band of 1,480 nm is typically used in long-distance optical fiber transmission systems. Recently, however, the band of 980 nm is also remarked because of its low noise property.

Optical outputs from the pumping lasers 54 and 56 enter into a half mirror (or prism) 58, maintaining their crossing status of polarization, and are multiplexed there. That is, the half mirror 58 is a polarizing beam splitter having reflecting/transmitting characteristics for passing polarized optical output from one of the pump lasers 54 and 56 and reflecting polarized optical output from the other.

Multiplexed laser light from the half mirror 58 enters into two main axes of a fiber grating 60 using a polarization-preserving PANDA fiber. The reflectance of the fiber grating 60 is set to several percent. As to its reflective wavelengths, there is a slight difference of approximately 0.4 nm, for example, in directions of the main axes due to a birefringence of the polarization-preserving fiber. Let the reflective wavelengths of the main axes be λ1 and λ2, respectively. The half mirror 58 and the fiber grating 60 are located so that reflected light from the fiber grating 60 runs in the opposite direction from the incident light and again enters into the pumping lasers 54 and 56 through the half mirror 58.

Laser light (pumping light) passing through the fiber grating 60 enters into a 3 dB coupler 62, and the 3 dB coupler 62 divides the input light into two divisional parts. The 3 dB coupler 62 may be of a polarization-preserving type so that each of orthogonal pumping light components be substantially equally distributed to these two divisional parts of light. The 3 dB coupler is optical fiber coupler, a beam splitter using a crystal or a waveguide structure using a quartz substrate. One of outputs of the 3 dB coupler 62 is connected to the pump input of the WDM coupler 50U, and the other output is connected to the pump input of the WDM coupler 50D.

Explained below are operations of the embodiment. The pumping lasers 54 and 56 are driven by D.C. current or modulated by a low frequency of 1 MHz or less for laser oscillation near the wavelengths λ1 and λ2, and their optical outputs are entered into the fiber grating 60 via the half mirror 58. The fiber grating 60 reflects part of the incident light back to the pumping lasers 54, 56 via the half mirror 58.

Since the fiber grating 60 is a polarization-preserving fiber, the polarization is preserved before and after the reflection. Therefore, the half mirror 58 returns the light from the pumping laser 54 reflected by the fiber grating 60 to the pumping laser 54, and the light from the pumping laser 56 reflected by the fiber grating 60 to the pumping laser 56.

Since the fiber grating 60 is birefringent and has two main axes whose reflective wavelengths λ1 and λ2 are slightly different by 0.4 nm or so, it functions as a reflecting element of a low reflectance of the reflective wavelength λ1, for example, for the pump laser 54, and functions as a reflecting element of a low reflectance of reflective wavelength λ2 for the pump laser 56.

As a result, the laser oscillation wavelength of the pumping laser 54 is locked at wavelength λ1, and that of the pumping laser 56 at λ2. As will be explained later, small amounts of return light of residual pumping light may enter into the pumping lasers 54, 56. However, since they are much weaker than the reflective light intensities from the fiber grating 60, even if there is any return light of a different wavelength derived from the pumping light of one of the pump lasers 54, 56 and entering into the other pumping laser, influence to the oscillation wavelength of the latter pumping laser is negligibly small, and the two pumping lasers 54, 56 do not synchronize in oscillation wavelength.

The pumping lasers 54, 56, half mirror 58 and optical fiber grating 60 using a PANDA fiber can control oscillation wavelengths of two pumping lasers 54, 56 to slightly different wavelengths. Since the difference between the reflective wavelengths of main axes due to the birefringence of the PANDA fiber does not vary largely with temperature or other factors, oscillation wavelengths of the pumping lasers 54, 56 seldom overlap.

Pumping light of wavelength λ1 and λ2 passing through the fiber grating 60 is divided into two divisional parts by the 3 dB coupler 62. One of outputs of the 3 dB coupler 62 is entered into the erbium-doped optical fiber 48U through the WDM coupler 50U and pumps the fiber 48U. The other output of the 3 dB coupler 62 is entered into the erbium-doped optical fiber 48D through the WDM coupler 50D and pumps the fiber 48D. As a result, the erbium-doped optical fibers 48U optically amplifies the output light from the transmission optical fiber 44U, and the erbium-doped optical fiber 48D optically amplifies output light from the transmission optical fiber 44D.

The light optically amplified by the erbium-doped optical fibers 48U, 48D passes through the WDM couplers 50U and 50D and further through the optical isolators 52U and 52D, and enters into the transmission optical fibers 46U, 46D.

Although the pumping light of the erbium-doped optical fibers 48U, 48D is absorbed in the erbium-doped optical fibers 48U, 48D, part of it passes through them and enters into the transmission optical fibers 46U, 46D on the input side of the optical amplifier 40. Part of the entered light thereafter re-enters into the erbium-doped optical fibers 48U and 48D due to Rayleigh back-scattering, or the like, in the transmission optical fibers 44U, 44D.

Such return light travels through the erbium-doped optical fibers 48U, 48D in the same direction as the signal light, and enters into the fiber grating 60 through the WDM couplers 50U, 50D and the 3dB coupler 62, like that in conventional devices. Although a small part of the light is reflected by the fiber grating 60, its most part passes through and enters into the half mirror 58. The return light is greatly lowered in polarization rate. In the half mirror 58, it is directed to the pumping lasers 54, 56, depending on the state of polarization, and enters into the pumping lasers 54, 56. However, as explained before, the light reflected by the fiber grating 60 is much more intensive than the return light, and oscillation wavelength of the pumping lasers 54, 56 are locked to the reflected wavelengths from the fiber grating 60. Therefore, oscillation wavelength of one of the pumping lasers 54, 56 is not affected by the return light derived from the other.

Needless to say, the reflectance of the fiber grating 60 is sufficient to ensure entry of an amount of reflective light sufficient for drawing oscillation wavelengths of the laser diodes 54, 56 into λ1 and λ2. Excessively high reflectance will result in decreasing amounts of pumping light for the erbium-doped optical fibers 48U, 48D.

In the band of 980 nm remarked as pumping light for erbium-doped optical fibers because of its low noise property, erbium-doped optical fibers exhibit sharp absorption characteristics, and fluctuation in oscillation wavelength of a pumping laser as small as several nanometers greatly affects amplification characteristics of erbium-doped optical fibers. Oscillation wavelengths of laser diodes, in general, vary with temperature and injected current. In this embodiment, however, since reflective wavelength of the fiber grating 60 relatively stable against temperature (fluctuation in reflective wavelength per 1 centigrade is as small as 0.01 to 0.02 nm) contributes to locking oscillation wavelengths of the pumping lasers 54, 56, stable optically amplifying characteristics can be obtained. Additionally, since the birefringence of the PANDA fiber always ensures a slight difference in oscillation wavelength between the pumping lasers 54, 56, the problem of conventional devices, namely, fluctuation in power of pumping light caused by an interference, does not occur.

Although the foregoing embodiment has been described as part of the pumping light for pumping the erbium-doped optical fibers 48U, 48D being used also for controlling the oscillation wavelengths of pumping lasers 54, 56, the invention is not limited to this. If second optical outputs can be obtained from the pumping lasers 54, 56, then the optical outputs can be used to arrange the same construction as the half mirror 58 and the fiber grating 60 and to control the oscillation wavelengths.

In lieu of the fiber grating 60 using a PANDA fiber, an element having a grating formed in a birefringent waveguide on a quartz substrate may be used. Apparently, any other similar optical element having acceptable temperature characteristics may be used instead of it.

The portion including the lasers 54, 56, half mirror 58 and fiber grating 60 can be used as a device for generating different kinds of laser light stable in wavelength and slightly different in wavelength. Apparently, by adding dividing means such as 3 dB coupler 62, if necessary, a plurality of laser outputs can be obtained.

Those skilled in the art will readily understand from the foregoing description that the invention, capable of holding wavelengths of redundantly arranged pumping light sources slightly different from each other, can stably pump optically amplifying mediums and can obtain stable amplifying characteristics.

It is also possible to obtain a plurality of laser outputs having stable and slightly different wavelengths.

## Claims

1. An optical amplifying apparatus comprising at least one optically amplifying medium, a pumping light source for generating pumping light for said optically amplifying medium and optical transmission means for supplying output light from the pumping light source to said optically amplifying medium characterized in that said pumping light source comprises a plurality of pumping lasers each generating pumping light and wavelength locking means for locking oscillation wavelengths of said pumping lasers to predetermined values slightly different from each other.

2. An optical amplifying apparatus comprising:
first and second optically amplifying mediums;
two pumping lasers;
multiplexing means for multiplexing optical outputs of said two pumping lasers in an orthogonally polarized state;
reflecting means having different reflective wavelengths between two orthogonal axes for reflecting parts of output light from said multiplexing means;
dividing means for dividing light passing through said reflecting means into two parts;
first coupling means for coupling one of optical outputs of said dividing means to said first optically amplifying medium; and
second coupling means for coupling the other of optical outputs of said dividing means to said second optically amplifying means.

3. A laser light generating apparatus comprising a plurality of lasers for generating laser light, and wavelength locking means for locking oscillation wavelengths of said lasers at predetermined values different from each other.

4. The apparatus according to claim 1 or 3 wherein said wavelength locking means comprises multiplexing means for multiplexing optical outputs from said lasers in different directions of polarization from each other, and reflecting means having slightly different reflective wavelengths depending on said directions of polarization for reflecting at least part of output light from said multiplexing means.

5. The apparatus according to claim 2 or 4 wherein said multiplexing means comprises transmitting and reflecting means having a polarization selective property which permits polarized light in one of said two orthogonal directions of polarization to pass through and reflects polarized light in the other direction of polarization.

6. The apparatus according to claim 2, 4 or 5 wherein said reflecting means comprises a diffraction grating element made of a birefringent optical material.

7. The apparatus according to claim 2, 4 or 5 wherein said reflecting means comprises a fiber grating using a polarization-preserving fiber.

8. The apparatus according to anyone of claims 3 to 7 further comprising dividing means for dividing light passing through said reflecting means into parts directed to individual said optically amplifying mediums.

9. The apparatus according to anyone of the foregoing claims wherein said respective optically amplifying medium comprises optical fibers doped with a rare earth.

10. The apparatus according to anyone of claims 4 to 9 wherein said pumping light source further comprises pumping light transmission means for supplying each said optically amplifying medium with light passing through said reflecting means.
